Europäisches Patentamt

European Patent Office

Office européen des brevets

(11) Numéro de publication: **0 290 780**
**A1**

## (12) DEMANDE DE BREVET EUROPEEN

(21) Numéro de dépôt: **88105458.9**

(22) Date de dépôt: **06.04.88**

(51) Int. Cl.4: **G01R 15/07**

(30) Priorité: **10.04.87 FR 8705102**

(43) Date de publication de la demande:
**17.11.88 Bulletin 88/46**

(84) Etats contractants désignés:
**BE CH DE ES FR GB IT LI LU NL SE**

(71) Demandeur: **ALSTHOM**
**38, avenue Kléber**
**F-75784 Paris Cédex 16(FR)**

(72) Inventeur: **Dupraz, Jean-Pierre**
**7 rue de la Paix**
**F-73100 Aix les Bains(FR)**

(74) Mandataire: **Weinmiller, Jürgen et al**
**Lennéstrasse 9 Postfach 24**
**D-8133 Feldafing(DE)**

(54) **Dispositif de mesure d'intensité d'un courant électrique par effet Faraday mis en oeuvre au sein d'un interféromètre de Sagnac.**

(57) Ce dispositif de mesure d'intensité d'un courant électrique met en oeuvre un interféromètre de Sagnac comportant dans sa boucle optique des moyens de modulation de phase (18, 19) permettant de moduler l'écart de phase des deux ondes lumineuses contrapropagatives qui y circulent, et des moyens électroniques de traitement (32, 33) du signal de photodétecteur (14) recevant le battement des deux ondes. Il est remarquable par le fait qu'il comporte des moyens de modulation d'amplitude (70) agissant sur la puissance d'émission de la source lumineuse (12) et en ce que les moyens électroniques de traitement comportent un démodulateur synchrone (32) opérant à la fréquence du battement inférieur des modulations d'amplitude et de phase et non à celle très élevée de la modulation de phase.

FIG.3

## Dispositif de mesure d'intensité d'un courant électrique par effet Faraday mis en oeuvre au sein d'un interféromètre de Sagnac

La présente invention se rapporte à la mesure des courants électriques et trouve plus particulièrement son application dans le domaine des réseaux de transport et distribution d'énergie.

La protection et la gestion des réseaux d'énergie électrique nécessitent la mesure de courants et tensions de valeurs élevées car les intensités en jeux sont couramment de plusieurs milliers d'ampères et les tensions de plusieurs centaines de milliers de volts.

Aujourd'hui, cette mesure est largement assurée par des moyens classiques, faisant appel à des principes physiques tels que la mutuelle induction entre conducteurs (transformateurs) et à des matériaux tels que porcelaine, huile et papier pour assurer l'isolation entre les conducteurs placés au potentiel élevé et les conducteurs secondaires, à basse tension placés à un potentiel proche de celui de la terre.

Si les performances, en terme de mesure de courant, sont satisfaisantes en courant alternatif, la mesure de courants continus sous très haute tension est encore délicate. De plus, les conditions sévères d'environnement et d'exploitation des appareils conduisent les utilisateurs à rechercher des appareils à haute sécurité. En effet les défaillances des transformateurs de courant classiques, si rares soient-elles, peuvent avoir des conséquences graves en raison des énergies considérables mises en jeux dans les réseaux électriques à haute tension.

Pour parvenir à ces objectifs de haute sécurité on cherche depuis longtemps à mettre en oeuvre l'effet Faraday qui fait appel à une onde lumineuse et supprime la nécessité d'avoir à placer des conducteurs électriques d'un circuit de mesure à proximité immédiate de la haute tension.

L'effet Faraday est un effet magnéto-optique résultant de l'interaction d'une onde électromagnétique et d'un milieu matériel, en présence d'un champ magnétique.

Certains milieux matériels présentent, sous l'action d'un champ magnétique de même direction que celle de l'onde électromagnétique, une activité optique se traduisant par une biréfringence induite, non réciproque, c'est-à-dire par des vitesses de propagation de l'onde dans le milieu, différentes selon que l'onde est à polarisation circulaire dextrogyre ou lévogyre.

Une manière de mettre en oeuvre l'effet Faraday pour la mesure de courant électrique consiste à utiliser une technique interféromètrique dite de Sagnac avec des ondes électromagnétiques à polarisation circulaire.

La technique interféromètrique de Sagnac consiste à faire interférer entre elles deux ondes électromagnétiques à polarisation circulaire provenant d'une même source et ayant effectué le même parcours en sens inverses. Cette technique permet de faire ressortir les effets d'une biréfringence non réciproque due à l'effet Faraday et de s'affranchir des effets des biréfringences réciproques induites par des contraintes thermiques ou mécaniques exercées sur le milieu de propagation constituant la boucle interféromètrique.

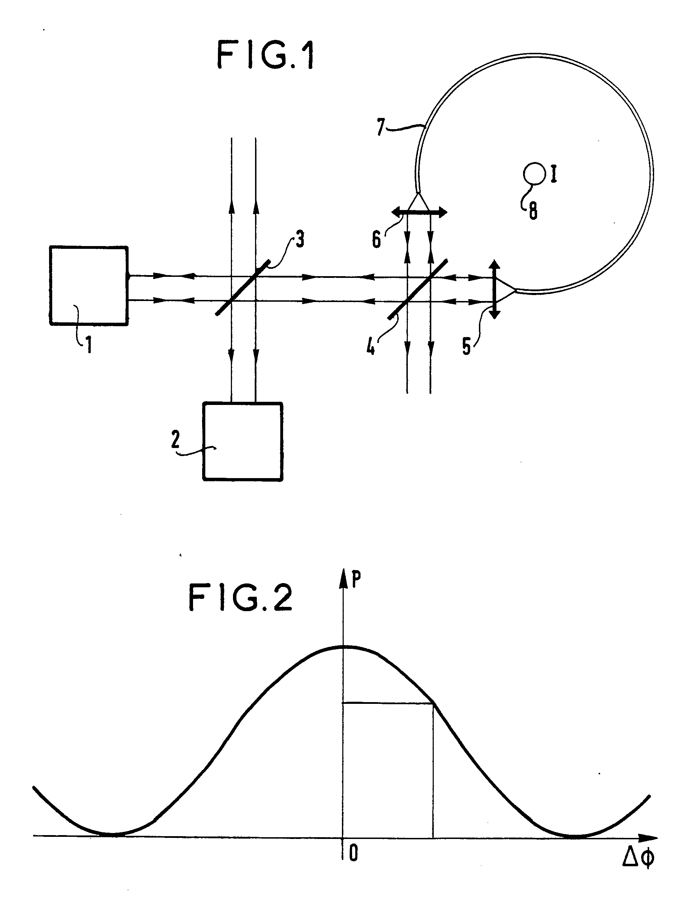

On connaît déjà divers dispositifs de mesure de courant par effet Faraday utilisant un interféromètre de Sagnac, notamment ceux décrits dans la demande de brevet français FR-A-2 461 956. La figure 1 en donne un schéma de principe. Une source cohérente 1 émet une onde lumineuse qui après traversée de deux lames séparatrices 3 et 4, donne naissance à deux ondes contrapropagatives couplées par des optiques 5 et 6 aux deux extrémités d'une fibre optique monomode 7 entourant un conducteur électrique 8 traversé par un courant I à mesurer. Ces deux ondes parcourent en sens inverses l'une de l'autre l'anneau formé par la fibre optique 7, se recombinent sous l'action de la lame séparatrice 4 puis, après réflexion sur la lame séparatrice 3, interfèrent au niveau d'un photodétecteur 2.

Le champ magnétique engendré par le courant circulant dans le conducteur électrique 8 crée dans l'anneau de fibre optique 7, par effet Faraday, une biréfringence non réciproque donnant aux deux ondes contrapropagatives des vitesses de parcours différentes. Dans le cas où ces deux ondes contrapropagatives sont polarisées circulairement de façon identique soit dextrogyre soit lévogyre il en résulte entre elles, en sortie de la boucle de l'interféromètre, au niveau du photodétecteur 2, un déphasage $\Delta \phi$ proportionnel à l'intensité I du courant électrique parcourant le conducteur 8. Le photodétecteur 2 engendre un signal proportionnel à la puissance optique P des deux ondes c'est-à-dire :

$$P = P1 + P2 + 2 \sqrt{P1.P2} \cos \Delta \phi \qquad (1)$$

(P1 et P2 étant les puissances optiques de chacune des ondes).

Cette loi de détection représentée à la figure 2 est une loi cosinuoïdale. Elle a l'inconvénient d'avoir une sensibilité nulle dans la plage des petits courants à mesurer où l'on cherche au contraire un maximum de précision et d'être en outre difficile à utiliser en raison des bruits qui accompagnent le signal de mesure et qui sont dus aux ondes de rétrodiffusion apparaissant aux discontinuités créées par les dispositifs optiques placés sur le parcours des ondes lumineuses.

Pour améliorer la sensibilité de détection, il est connu par le brevet français FR-A-2 475 230, d'utiliser une détection cohérente à balance hétérodyne pour mesurer la puissance des deux faisceaux issus de l'interféromètre. Cette détection cohérente consiste en une sorte de démodulation optique synchrone et en quadrature réalisée sur la somme des deux faisceaux issus de l'interféromètre en fractionnant cette somme en deux parties pour les faire battre en phase et en opposition de phase avec le faisceau lumineux initial et en détectant ces battements à l'aide de deux détecteurs couplés aux entrées d'un amplificateur différentiel. Cette méthode permet de s'affranchir du bruit de la source lumineuse et de doubler la sensibilité de détection mais cela au prix d'une augmentation importante de la complexité du système optique.

Pour améliorer la sensibilité de détection il est également connu, par le brevet français FR-A-2 461 956 de moduler l'angle de déphasage entre les deux ondes lumineuses contrapropagatives parcourant la boucle de l'interféromètre en provoquant dans cette dernière, des phénomènes de biréfringence soit non réciproques par modulation de l'intensité d'un courant parcourant une bobine auxiliaire engendrant un champ magnétique de référence soit réciproques mais pulsés à la demi-fréquence de résonance de la boucle de l'interféromètre, dite fréquence propre de l'interféromètre, de manière à provoquer des écarts de phase instantanés égaux mais de signes opposés sur les deux faisceaux lumineux par effet élasto-optique ou électro-optique.

L'ajout de ces phénomènes de biréfringences réciproques ou non a pour effet de transformer l'expression de la puissance lumineuse P des deux ondes lumineuses issues de l'interféromètre, de la manière suivante :

$$P = P1 + P2 + 2\sqrt{P1\,P2}\cos[\Delta\phi + \alpha\cos(2\pi ft + \beta)]$$

Cette puissance lumineuse P possède un spectre de fréquence riche en composantes avec notamment :
- un composante continue,
- une composante à la fréquence f de modulation proportionnelle à sin $\Delta\phi$ ayant un maximum de variation dans la plage des petits courants,
- une composante au double de la fréquence f de modulation proportionnelle à cos $\Delta\phi$ qui s'annule avec le courant à mesurer.

La composante à la fréquence de modulation permet d'avoir un maximum de sensibilité dans la plage des petits courants. Malheureusement elle doit être isolée par une démodulation synchrone très délicate à réaliser en raison de l'ordre de grandeur élevé de la fréquence propre de l'interféromètre qui est de 10 MHz pour une longueur de fibres de 10 mètres, longueur réaliste compte tenu des dimensions courantes d'un réducteur de mesure haute tension imposées par les distances d'isolement à respecter.

La présente invention a pour but de remédier à l'inconvénient précité et d'obtenir un dispositif de mesure d'intensité électrique répondant aux besoins exprimés en matière de transport d'énergie électrique continue ou alternative sous haute tension avec une grande sécurité et un prix de revient qui ne soit pas prohibitif.

Elle a pour objet un dispositif de mesure d'intensité d'un courant électrique par effet Faraday mis en oeuvre au sein d'un interféromètre de Sagnac qui comporte :
- une source lumineuse,
- un interféromètre de Sagnac comprenant une fibre optique formant au moins une spire enroulée autour d'un conducteur électrique dans lequel circule un courant à mesurer, des moyens optiques pour extraire du faisceau lumineux délivré par la source, deux ondes lumineuses polarisées circulairement de façon identique parcourant la fibre optique en sens inverse, et pour recombiner ces deux ondes lumineuses en sortie de l'interféromètre et les faire battre sur un photodétecteur, et ledit photodétecteur,
- des moyens de modulation de phase agissant sur la phase des deux ondes lumineuses circulant en sens inverses dans la fibre optique pour moduler leur écart de phase et,
- des moyens électroniques de traitement du signal du photodétecteur procédant par une démodulation synchrone.

Ce dispositif de mesure est remarquable en ce qu'il comporte en outre des moyens de modulation d'amplitude agissant sur la puissance lumineuse de la source et en ce que ses moyens électroniques de traitement du signal comportent un démodulateur synchrone opérant à la fréquence du battement inférieur des modulations d'amplitude et de phase.

Cette fréquence de battement qu'il est possible d'ajuster par le choix de la fréquence de la modulation d'amplitude peut être choisie inférieure à 100 kHz dans une gamme où la démodulation synchrone est facile à réaliser à moindre coût.

Selon un mode préféré de réalisation, la modulation d'amplitude est une modulation par tout au rien qui a pour avantage de diminuer la cohérence du faisceau lumineux émis par la source et par conséquent celle des interférences parasites dues aux rétrodiffusions qui voient leurs effets minimisés.

D'autres caractéristiques et avantages de l'invention ressortiront de la description ci-après d'un mode de réalisation donné à titre d'exemple. Cette description sera faite en regard du dessin dans lequel :

- une figure 1 représente le schéma de principe d'un interféromètre de Sagnac à sortie réciproque utilisé pour la mesure d'intensité de courant électrique par l'effet Faraday,

- une figure 2 représente la relation existant entre la puissance optique détectée P en sortie de l'interféromètre de Sagnac de la figure 1 et le déphasage relatif non réciproque provoqué par effet Faraday sur les faisceaux lumineux le parcourant,

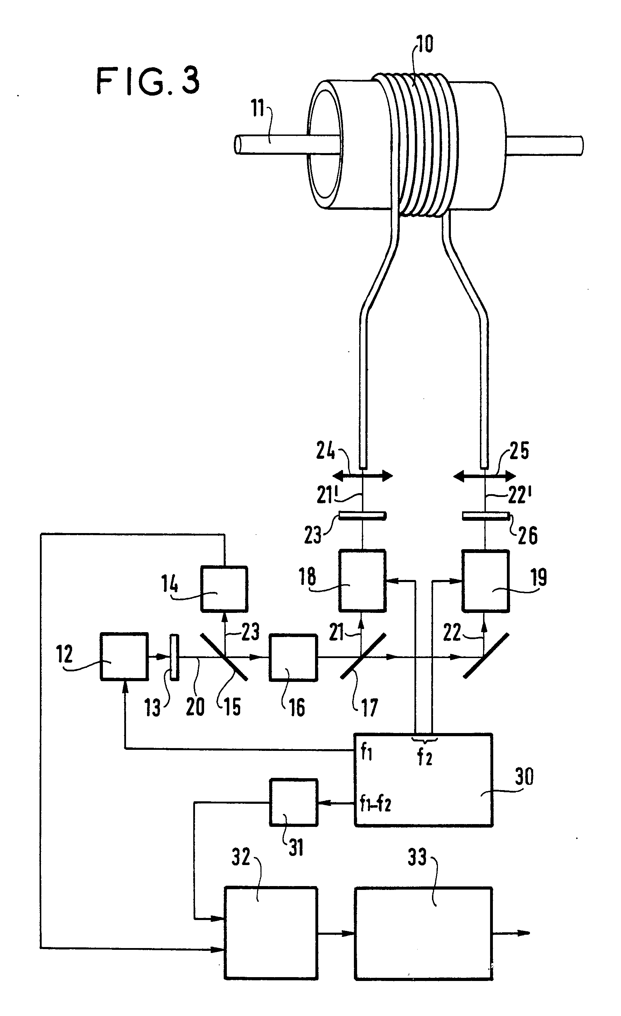

- une figure 3 représente le schéma de principe d'un dispositif de mesure d'intensité de courant selon l'invention,

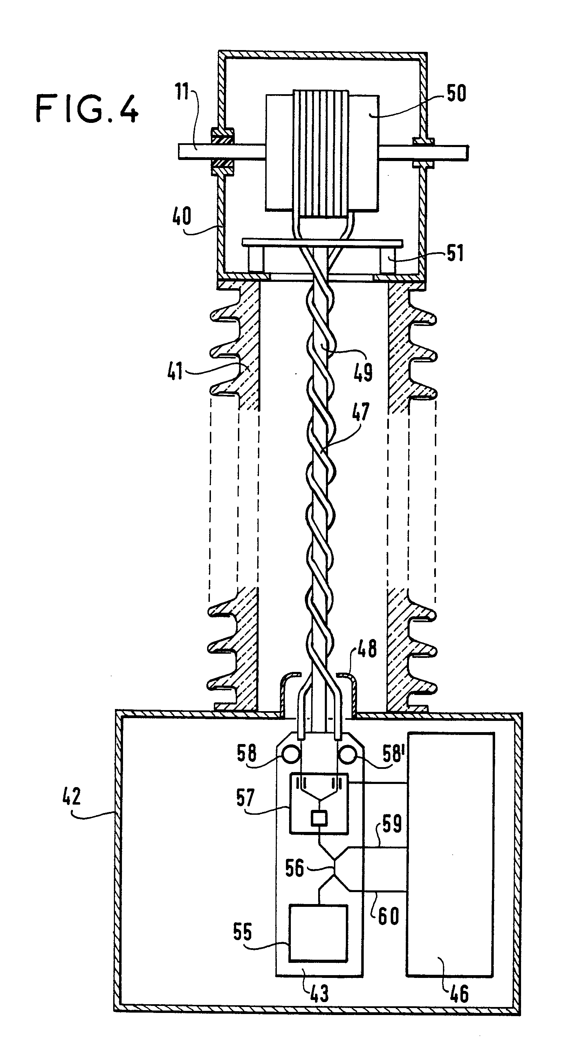

- une figure 4 représente la disposition pratique des éléments du dispositif de mesure d'intensité de la figure 3 et

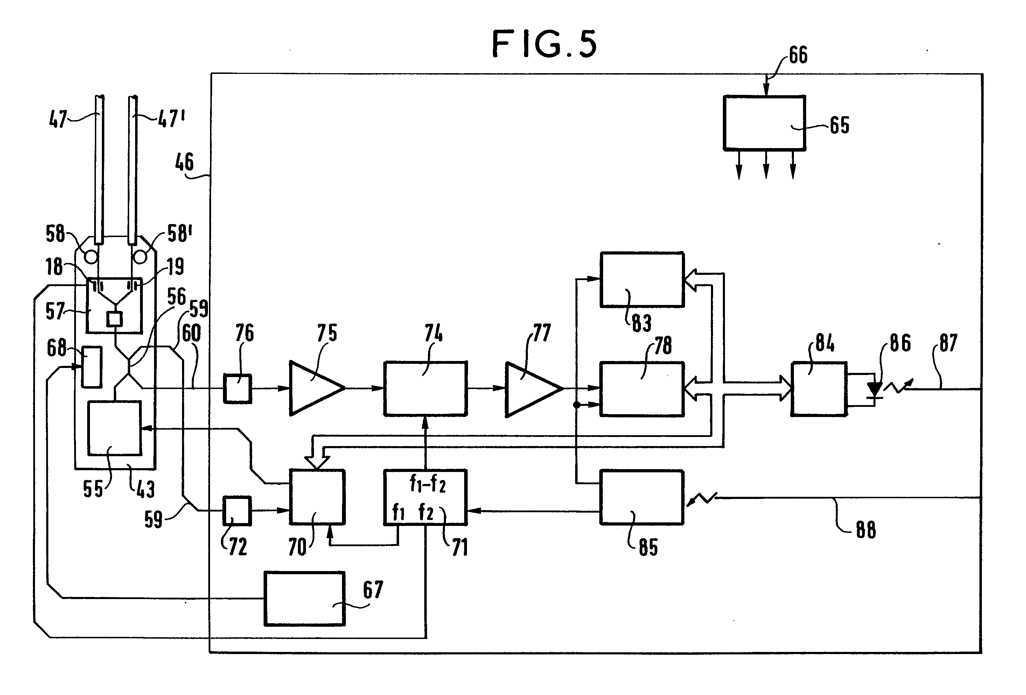

- une figure 5 détaille la partie électronique de traitement de signal du dispositif de mesure d'intensité de la figure 3.

Le dispositif qui va être décrit est destiné à la mesure d'intensité de courants électriques alternatifs dans un appareillage haute tension. Son schéma de principe est représenté à la figure 3. Une fibre optique 10 monomode à haute biréfringence circulaire entoure une ou plusieurs fois un conducteur électrique traversé par un courant alternatif I1 sin $\omega t$ dont on veut mesurer l'intensité. Une source de lumière cohérente 13 émet un faisceau lumineux 20 dont la polarisation peut être ajustée angulairement par un dispositif demi-onde 13, et qui traverse une lame séparatrice 15, puis un polariseur 16, et se sépare sur une lame séparatrice 17 en deux ondes lumineuses 21 et 22 à polarisation linéaire.

L'onde lumineuse 21 traverse alors un modulateur de phase 18, puis une lame quart d'onde 23 la transformant en une onde lumineuse 21' à polarisation circulaire. Cette onde lumineuse 21' est introduite dans la fibre optique 10 au moyen d'une optique 24. Après propagation autour du conducteur 11, elle émerge de la fibre optique 10 par une optique 25 et traverse une lame quart d'onde 26 la retransformant en une onde lumineuse à polarisation linéaire avec, en l'absence d'effet Faraday, un plan de polarisation de même orientation que celui des ondes lumineuses 21 et 22. Elle traverse ensuite un modulateur de phase 19, commandé en opposition de phase relativement au modulateur 18, puis la lame séparatrice 17, le polariseur 16, se réfléchit sur la lame séparatrice 15, et frappe la surface sensible du photodétecteur 14. L'onde lumineuse 22 effectue le même trajet, mais en sens inverse, de sorte qu'elle traverse successivement le modulateur 19, la lame quart d'onde 26, la fibre 10, la lame quart d'onde 23 le modulateur 18, se réfléchit sur la lame séparatrice 17, traverse le polariseur 16, se réfléchit encore sur la lame séparatrice 15 et frappe le photodétecteur 14, au niveau duquel elle interfère avec l'onde lumineuse précédente.

Le faisceau unique 20 a ainsi donné naissance à deux ondes polarisées circulairement, toutes deux dextrogyres ou toutes deux lévogyres, qui ont fait une ou plusieurs fois le tour du conducteur 11, mais en sens inverses, dans le milieu matériel que constitue la fibre optique 10.

La mise en oeuvre de la fibre optique 10 est telle qu'elle lui confère d'une part une très forte biréfringence circulaire, et d'autre part, une insensibilisation aux vibrations mécaniques. Ceci est obtenu en torsadant la fibre sur elle-même, et en l'enrobant d'un gel silicone. Les rayons de courbure de la fibre sont aussi grands que possible, pour minimiser les effets des biréfringences linéaires associées aux contraintes de courbure. L'ensemble des composants optiques autres que la fibre optique 10 est placé en dehors du potentiel élevé du courant à mesurer sur une platine optique compacte. La fibre optique 10 constitue un milieu de propagation continu, sans raccord ni soudure, propre à assurer une bonne conservation de polarisation circulaire à la fois autour du conducteur électrique dont l'intensité de courant est à mesurer et sur le trajet du conducteur à la platine optique.

Le passage du courant I1 sin $\omega t$ dans le conducteur 11 engendre une biréfringence non réciproque dans la fibre optique 10, procurant aux ondes lumineuses contrapropagatives un déphasage relatif $\Delta \phi$ proportionnel à son intensité :

$$\Delta \phi = k1 \ I1 \ \sin \omega t \qquad (1)>$$

Ces deux ondes lumineuses interfèrent au niveau du détecteur optique 14 et délivrent une puissance optique maximum en l'absence de courant et de modulation car elles suivent alors des chemins optiques identiques.

Les modulateurs de phase 18, 19 sont commandés en opposition par une tension variant sinuoïdalement à une fréquence f2 choisie le plus proche possible de la fréquence propre de l'interféromètre sans toutefois la dépasser. De cette manière, les modulateurs 18 et 19 engendrent à tout instant, sur les deux ondes contrapropagatives, des déphasages égaux mais de signes opposés d'amplitude périodique, qui s'ajoutent au déphasage $\Delta \phi$ de l'effet Faraday. Ils modifient l'expression de la puissance optique P du faisceau résultant de la manière suivante :

$$P = P1 + P2 + 2\sqrt{P1\ P2}\ \cos\ [\Delta \phi + \alpha \cos\ (2\pi f2t + \beta)] \qquad (2)$$

$\alpha$ étant un coefficient de taux de modulation de phase.

Simultanément, la puissance optique de la source de lumière cohérente 12 est modulée en amplitude, sinuoïdalement, à une fréquence f1 légèrement supérieure à la fréquence f2 donnant aux puissances P1 et P2 des faisceaux lumineux entrant dans l'interféromètre une loi, de variation de la forme.

$$P1 = Po1\ (1 + m\ \sin\ 2\pi f1t)$$
$$P2 = Po2\ (1 + m\ \sin\ 2\pi f1t)$$

Po1, Po2 étant des constantes et m un taux de modulation d'amplitude, de sorte que la puissance optique P du faisceau résultant en sortie de l'interféromètre répond à la relation :

$$P = (1 + m\ \sin\ 2nf1t)[Po1 + Po2 + 2\sqrt{Po1\ Po2}\ \cos\ (\Delta \phi + \cos\ (2\pi f2t + \beta)] \qquad (3)$$

L'analyse mathématique de cette relation au moyen des fonctions de Bessel montre que la puissance optique P du faisceau issu de l'interféromètre possède un spectre de fréquence très riche en harmoniques avec une raie à la fréquence f1-f2 qui peut être isolée par filtrage et démodulation et dont la puissance P' est proportionnelle au sinus du déphasage $\Delta \phi$ du à l'effet Feraday.

$$P' = \tfrac{1}{2}m\ Po\ J1\ (\alpha)\ \sin\ \Delta \phi\ \sin\ (2\pi(f1\text{-}f2)\ t + \phi) \qquad (4)$$

(J1 étant une fonction de Bessel de première espèce d'ordre 1)

Un générateur synthétiseur de fréquence 30 élabore un signal de commande de modulation de l'amplitude de la puissance d'émission de la source lumineuse 12 à la fréquence f1, des signaux de commande des modulateurs de phase 18, 19 à la fréquence f2 et un signal d'horloge à la fréquence f1-f2 pour un circuit de détection synchrone 32. Le signal de sortie du détecteur optique 14 est injecté, après amplification et filtrage par un circuit 31, à l'entrée du circuit de détection synchrone 32. Celui-ci est suivi d'un circuit d'amplification et de filtrage 33 qui délivre en sortie un signal s(t) permettant de connaître l'intensité du courant à mesurer avec un maximum de sensibilité dans la plage des petits courants car son amplitude est proportionnelle au sinus de l'angle de déphasage engendré par effet Faraday et par conséquent au sinus de l'intensité de courant I1 à mesurer

$$s(t) = k2\ \sin\ (k1\ I1\ \sin\ \omega t) \qquad (5)$$
d'ou :

$$I1\ \sin \omega t = \frac{1}{k1}\ \text{Arc}\ \sin\ \frac{s(t)}{k2} \qquad (6)$$

Cette technique de double modulation permet d'effecteur la démodulation synchrone à une fréquence f1-f2 beaucoup plus basse que la fréquence propre de l'interféromètre ce qui a deux avantages immédiats : permettre de réduire au minimum la longueur de fibre optique monomode 10 dans la boucle de l'interféromètre car celle-ci est sensible par nature aux perturbations mécaniques à l'origine de couplages de modes de propagation, et simplifier la réalisation de la détection synchrone. En effet, une longueur de fibre optique de 10 mètres pour la boucle de l'interféromètre qui est un ordre de grandeur réaliste, conduit à une fréquence propre de l'interféromètre de l'ordre de 10 MHz pour laquelle la réalisation d'un circuit de détection synchrone est très délicate. La modulation de la puissance d'émission de la source lumineuse à une fréquence voisine par exemple de 10,05 MHz permet de ne plus faire travailler le circuit de détection synchrone 32 qu'à une fréquence de 50 kHz.

Cela permet également une standardisation de la partie délicate du traitement du signal placée en aval du circuit de détection synchrone 32 en maintenant la fréquence intermédiaire fo constante même si la longueur de la fibre optique varie d'un appareil à l'autre entraînant une variation de la fréquence propre de l'interféromètre car cette variation qui entraîne une variation de la fréquence f2 de modulation de phase peut être compensée par une variation correspondante de la fréquence f1 de la modulation d'amplitude.

La figure 4 représente un disposition préférentielle des éléments du dispositif de mesure de courant pour une application à des lignes de courants électriques à haute tension. On distingue sur cette figure 4 une tête de mesure 40 portée par une enveloppe isolante 41 et un soubassement 42. La tête de mesure 40 et l'enveloppe isolante 41 délimitent un volume intérieur, creux, étanche et conditionné de façon à assurer le fort isolement électrique nécessaire aux appareillages haute tension par exemple, grâce à un remplissage avec un gaz tel que de l'hexafluorure de souffre SF6, la colonne isolante 41 pouvant être en porcelaine ou en un matériau synthétique.

Le soubassement 42 de la colonne isolante 41 contient une platine optique 43 et une platine électronique 46.

La colonne isolante 41 contient essentiellement un mat isolant central 49 autour duquel s'enroule en hélice un câble isolant 47 de conditionnement de fibre optique aboutissant par ses deux extrémités dans le soubassement 42 et une cloison métallique pare-effluve 48 assurant un blindage électrostatique au sortir du soubassement 42.

La tête de mesure 40 renferme un mandrin isolant 50 qui entoure un conducteur électrique 11 traversé par un courant électrique alternatif à mesurer et sur lequel est bobinée la partie médiane du câble isolant 47 de conditionnement de fibre optique. Ce mandrin 50 est fixé au boîtier de la tête de mesure par l'intermédiaire d'un dispositif amortisseur 51 assurant le filtrage mécanique des vibrations.

Le câble isolant 47 renferme une fibre optique monomode à très faible biréfringence intrinsèque qui est torsadée sur elle même pour acquérir une très forte biréfringence circulaire et maintenue en l'état par un enrobage en gel de silicone constituant un excellent diélectrique et un bon amortisseur de vibrations mécaniques. Cette fibre optique qui constitue une boucle d'interféromètre de Sagnac part de la platine optique 43 disposée dans le soubassement 42, s'enroule en hélice autour du mat central 49 de l'enveloppe isolante 41, parvient dans la tête de mesure 40 où elle effectue plusieurs fois le tour du mandrin isolant 50 puis s'enroule à nouveau autour du mat central 49 de l'enveloppe isolante 41 pour revenir au soubassement 42 et retourner à la platine optique 43.

La platine optique 43 contient la source lumineuse 55, un coupleur directif monomode à polarisation linéaire 56, un circuit en technologie optique intégrée 57 assurant les fonctions de polariseur, de coupleur directionnel et de modulation de phase, et enfin deux boucles de fibre optique 58 et 58′ assurant les fonctions de lames quart d'onde. Elle est conditionnée dans une enceinte thermostatée assurant la protection climatique et mécanique et connectée optiquement à la platine électronique 46 par des fibres optiques multimodes constituant les deux branches de sortie 59 et 60 du coupleur directif 56, ces liaisons se faisant en fibre multimode car seule l'information puissance lumineuse est utile à leur niveau. Un connecteur électrique permet de relier les commandes électriques du circuit en technologie optique intégrée 57 et de la source lumineuse 55 à la platine électronique 46.

La figure 5 représente une vue détaillée de la platine électronique 46 et de ses connexions avec la platine optique 43.

La platine électronique 46 peut se décomposer en une partie émission engendrant les signaux électriques nécessaires à la double modulation d'amplitude et de phase des deux ondes lumineuses contrapropagatives parcourant l'interféromètre, en une partie réception extrayant du battement des deux ondes lumineuses contrapropagatives, à leur sortie de l'interféromètre, un signal proportionnel au sinus de l'intensité du courant à mesurer, en une partie d'exploitation numérique du signal de la partie réception assurant également la transmission de la mesure d'intensité vers l'extérieur du dispositif ainsi qu'une synchronisation éventuelle de cette mesure avec une référence temporelle externe, et en une partie de service comprenant une alimentation électrique 65 de la platine électronique 46 et une régulation thermique de la platine optique 43.

L'alimentation électrique 65 de la platine électronique 46 est de type à découpage. Elle délivre les diverses tensions de polarisation nécessaire et assure une isolation galvanique importante entre la platine électronique 46 et un câble électrique 66 provenant d'une alimentation électrique continue extérieure.

La régulation thermique de la platine optique 43 est assurée par un bloc de régulation 67 couplé à des éléments de mesure de température et de chauffage 68 intégrés à la platine optique 43.

La partie émission comporte un modulateur 70 de la puissance de la source lumineuse 55 et un générateur synthétiseur de fréquence 71. Le modulateur 70 est stabilisé par une boucle de contre-réaction incluant un photodétecteur 72 connecté à la fibre optique 59 constituant la sortie du coupleur directif 56 couplée à la source lumineuse 55. Il est pourvu d'une entrée de porteuse de modulation couplée à une sortie du générateur synthétiseur de fréquence 71. Le générateur synthétiseur de fréquence 71 pilote par une première sortie sur laquelle il délivre une fréquence f1, le modulateur de puissance 70, par une deuxième sortie sur laquelle il délivre une fréquence f2 les modulateurs optiques de phase du circuit en technologie intégrée 57 et par une troisième sortie sur laquelle il délivre une fréquence (f1-f2) un circuit de démodulation synchrone 74 de la partie réception. Il présente une entrée de synchronisation commandée par un circuit d'horloge 85 de la partie d'exploitation numérique du signal reçu.

La partie réception comporte un circuit de démodulation synchrone 74 précédé d'un circuit d'amplification et de filtrage 75 relié à la sortie d'un photodétecteur 76 connecté à la fibre optique 60 constituant la sortie du coupleur directif 56 couplée à l'interféromètre, et suivi d'un autre circuit d'amplification et de filtrage 77, et d'un convertisseur analogique-numérique 78.

Le photodétecteur 76 qui reçoit le battement des deux faisceaux lumineux contrapropagatifs issus de l'interféromètre délivre en sortie un signal proportionnel à la puissance lumineuse reçu qui, comme on l'a vu précédemment (relation 3) s'exprime, en raison des modulations d'amplitude f1 et de phase f2 par la relation :

$$P + (1 + m \sin 2\pi f1 \ t) [Po1 + Po2 + 2 \sqrt{Po1.Po2} \cos (\Delta \phi + \alpha \cos (2\pi f2t + \beta))]$$

Ce signal est filtré et amplifié par le circuit 75 pour en tirer une composante à la fréquence f1-f2 qui est proportionnelle à (relation 4) :

$$P' = \tfrac{1}{2} m \ Po \ J1 \ (\alpha) \sin \Delta \phi \sin (2\pi(f1-f2) \ t + \phi)$$

et qui, appliquée au circuit de démodulation synchrone 74 puis filtrée et amplifiée par le circuit 77, donne naissance à un signal s(t) de mesure d'intensité de la forme (relation 5)

$$s(t) = k2 \sin k1 \ I1 \sin \omega t$$

Ce signal est échantillonné et numérisé par le convertisseur analogique-numérique 78 qui comporte un échantillonneur-bloqueur commandé par la partie d'exploitation numérique du signal reçu et un dispositif de conversion analogique-numérique fonctionnant selon les techniques habituelles par exemple par approximations successives.

La partie d'exploitation numérique du signal de la partie réception comporte un processeur de traitement 83, un processeur de communication 84 et d'un circuit d'horloge 85.

Le processeur de traitement 83 a pour rôle principal d'extraire du signal s(t) de la partie réception disponible sous forme numérique en sortie du convertisseur analogique-numérique 78, une valeur explicite de l'intensité instantanée du courant à mesurer c'est-à-dire d'effectuer le calcul

$$I1 \cos \omega t = \frac{1}{k1} \ Arc \sin \frac{s(t)}{k2}$$

Il effectue cette tâche à chaque nouvelle valeur numérique reçue du convertisseur analogique-numérique 78 au moyen d'une table de définition de la fonction Arc sinus, des valeurs des constantes k1 et k2 déterminées par calibration de la chaîne de mesure et d'un algorithme approprié.

Le processeur de communication 84 assure le codage, la sérialisation et la transmission numérique selon un protocole normalisé à haute sécurité, par exemple de type HDLC, de la mesure instantanée d'intensité de courant délivrée par le processeur de traitement. Cette transmission vers l'extérieur se fait par l'intermédiaire d'une diode électroluminescente 86 et d'une fibre optique 87 monomode ou multimode constituant la sortie physique du dispositif de mesure.

Le circuit d'horloge 85 reçoit une synchronisation externe par l'intermédiaire d'une fibre optique monomode ou multimode 88. Il assure le synchronisme de fonctionnement du processeur de traitement 83 et du processeur de communication 84, ainsi que celui des prises d'échantillons par le convertisseur analogique-numérique 78 sur le rythme transmis, ce qui est nécessaire dans le cadre d'une utilisation du dispositif de mesure dans des postes électriques triphasés à haute tension où il importe que les mesures instantanées d'intensité soient simultanées sur les trois phases. Il délivre aussi un signal d'horloge stable utilisé par le générateur synthétiseur de fréquence f1 de la partie émission pour élaborer les porteuses de modulation f1, f2 ainsi que la porteuse de démodulation f1-f2 convenablement déphasée pour assurer un fonctionnement correct du circuit de démodulation synchrone 74.

On utilise avantageusement une source lumineuse à faible cohérence. Si la source lumineuse est une diode laser engendrant un faisceau lumineux d'une grande cohérence, on abaisse sa cohérence en le faisant fonctionner par tout ou rien en utilisant pour la porteuse de modulation d'amplitude une onde rectangulaire. Cela permet de décorréler les interférences parasites dues aux différentes rétrodiffusions des ondes lumineuses sur les couplers et polariseurs et de diminuer ainsi le bruit d'ambiance du signal délivré par la partie réception dont les composantes ne s'additionnent plus en amplitude mais en puissance.

## Revendications

1/ Dispositif de mesure d'intensité d'un courant électrique par effet Faraday mis en oeuvre au sein d'un interféromètre de Sagnac comportant :
- une source lumineuse (55),
- un interféromètre de Sagnac comprenant une fibre optique (10) formant au moins une spire autour d'un conducteur électrique (11) dans lequel circule un courant dont l'intensité est à mesurer, des moyens optiques (56, 57, 58, 58') pour extraire du faisceau lumineux fourni par la source lumineuse (55) deux ondes lumineuses polarisées circulairement de façon identique parcourant en sens inverse ladite fibre optique (10) et pour recombiner lesdites ondes lumineuses à leurs sorties de la fibre optique (10) et les faire battre sur un photodétecteur (76) et ledit photodétecteur (76),
- des moyens de modulation de phase (18, 19) des deux ondes lumineuses circulant dans la fibre optique (10), qui modulent l'écart de phase entre lesdites ondes lumineuses et
- des moyens électroniques (46) du traitement du signal du photodétecteur (76) procédant par démodulation synchrone,
ledit dispositif de mesure étant caractérisé en ce qu'il comporte en outre des moyens de modulation d'amplitude (70) agissant sur la puissance d'émission de la source lumineuse (55) et en ce que lesdits moyens électroniques de traitement du signal du photodétecteur (76) comporte un démodulateur synchrone (74) opérant à la fréquence du battement inférieur des modulations d'amplitude et de phase.

2/ Dispositif de mesure selon la revendication 1, caractérisé en ce que les moyens de modulation d'amplitude comportent un modulateur (70) stabilisé par une boucle de contre-réaction incluant un photodétecteur (72) recevant une partie du faisceau lumineux émis par la source lumineuse (55).

3/ Dispositif de mesure selon la revendication 2, caractérisé en ce que les moyens de modulation d'amplitude opèrent avec une porteuse sinuoïdale.

4/ Dispositif de mesure selon la revendication 1, caractérisé en ce que les moyens de modulation d'amplitude opèrent avec une porteuse rectangulaire provoquant un fonctionnement par tout ou rien de la source lumineuse (55).

5/ Dispositif de mesure selon la revendication 1, caractérisé en ce que les moyens de modulation d'amplitude opèrent à une fréquence supérieure à celle de la modulation de phase.

6/ Dispositif de mesure selon la revendication 1, caractérisé en ce que la source lumineuse (55) est une source à faible cohérence.

# FIG.1

# FIG.2

# FIG.3

FIG.4

FIG.5

0 290 780

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | FR-A-2 461 956 (THOMSON-CSF S.A.) <br> * Page 6, ligne 20 - page 7, ligne 4; figure 5 * | 1 | G 01 R 15/07 |
| A | EP-A-0 187 091 (THOMSON-CSF) <br> * Page 3, lignes 9-19; figure 1 * | 1 | |
| D,A | FR-A-2 475 230 (ELECTRICITE DE FRANCE) <br> * Page 5, ligne 7 - page 7, ligne 3; figure * | 1 | |
| A | ADVANCES IN INSTRUMENTATION, vol. 37, partie 3, 1982, pages 1655-1671, ISA, Research Triangle Park, NC, US; A.R. TEBO: "Sensing with optical fibers: An emerging technology" <br> * Figure 8 * | 1 | |
| A | ALTA FREQUENZA, vol. 53, no. 6, novembre 1984, pages 310-314, Milano, IT; S. DONATI et al.: "A fiber sensor for current measurements in power lines" <br> * Page 313, colonne de droite, ligne 27 - page 314, colonne de gauche, ligne 2; figure 5 * | 2 | |

**DOMAINES TECHNIQUES RECHERCHES (Int. Cl.4)**

G 01 R
G 02 F

Le présent rapport a été établi pour toutes les revendications

| Lieu de la recherche | Date d'achèvement de la recherche | Examinateur |
|---|---|---|
| LA HAYE | 11-08-1988 | PENZKOFER,B. |